(19) **Europäisches Patentamt**

**European Patent Office**

**Office européen des brevets**

(11) **EP 0 761 841 B1**

(12) **EUROPEAN PATENT SPECIFICATION**

| | |
|---|---|
| (45) Date of publication and mention of the grant of the patent:<br>**12.06.2002 Bulletin 2002/24** | (51) Int Cl.[7]: **C23C 16/40**, C23C 16/30,<br>H01L 21/00, C23C 16/56 |
| (21) Application number: **96112891.5** | |
| (22) Date of filing: **09.08.1996** | |

(54) **Method for forming film**

Verfahren zur Herstellung einer Schicht

Procédé de formation d'une couche

(84) Designated Contracting States:
**DE GB NL**

(30) Priority: **18.08.1995 JP 21089695**

(43) Date of publication of application:
**12.03.1997 Bulletin 1997/11**

(73) Proprietors:
* **CANON SALES CO., INC.**
**Minato-ku, Tokyo 108 (JP)**
* **SEMICONDUCTOR PROCESS LABORATORY CO., LTD.**
**Minato-ku, Tokyo 108 (JP)**

(72) Inventors:
* **Maeda, Kazuo,**
**Semiconductor Process Lab Co., Ltd.**
**Tokyo (JP)**

* **Tokumasu, N.,**
**Semiconductor Process Lab Co., Ltd.**
**Tokyo (JP)**
* **Yuyama, Yoshiaki**
**Fussa-shi, Tokyo (JP)**

(74) Representative: **Marx, Lothar, Dr.**
**Patentanwälte Schwabe, Sandmair, Marx**
**Stuntzstrasse 16**
**81677 München (DE)**

(56) References cited:
**EP-A- 0 517 548      EP-A- 0 572 704**
**EP-A- 0 654 545      US-A- 5 429 995**

## Description

BACKGROUND OF THE INVENTION

1. Field of the Invention

The present invention relates to a film forming method and, more particularly, a film forming method for forming a fluorine containing silicon oxide film in terms of a thermal CVD method.

2. Description of the Prior Art

In the prior art, most of interlayer insulating layer used for semiconductor devices are formed of $SiO_2$ film or $SiO_2$-based film. Such $SiO_2$-based insulating film is of a relative dielectric constant of about 4.0 (measuring frequency of 1 MHz). According to the above explanation, a capacitance C between upper and lower conductors sandwiching an interlayer layer, and between adjacent conductive layers putting the interlayer insulating film therebetween might be determined. In other words,

$$C = \varepsilon_0 \cdot \varepsilon \cdot A/t$$

Where

$\varepsilon_0$: dielectric constant in vacuum (=1),
$\varepsilon$: relative dielectric constant of interlayer insulating film,
A: overlapping area of upper and lower interconnection layers or opposing area between adjacent interconnection layers for convenience sake of calculation (However, it has to be actually taken account that contribution of areas between the interconnection layers other than the overlapping area, otherwise contribution of areas other than the opposing area between the interconnection layers), and
t: film thickness of the interlayer insulating film disposed between the upper and lower interconnection layers, or a space formed between adjacent interconnection layers sandwiching the interlayer insulating film.

Such parasitic capacitance resides in any kind of semiconductor device. However, if a value of such parasitic capacitance is considerably large, either a crosstalk between the interconnection layers would occurs or delay would be caused in signal propagation time. In particular, if a multilayered structure is utilized in order to achieve high integration density of the semiconductor device, parasitic capacitance would be increased since overlapping areas or opposing areas between the interconnection layers are increased. Furthermore, since a space between the adjacent interconnection layers is narrowed if dimensions of the patterns are made fine, there are some cases where the space between adjacent interconnection layers become small rather than the space between the upper and lower interconnection layers. For this reason, the parasitic capacitance is increased. Therefore influence of the parasitic capacitance on the device characteristics cannot be ignored.

EP-A-0 517 548 discloses CVD method for forming a F-containing SiO2 film comprises introducing a gaseous mixture of alkoxysilane or its polymers as a source gas with fluoroalkoxysilane into a reaction chamber and decomposing the gaseous mixture to deposit the F-containing SiO2-film onto a substrate. Preferably alkoxysilane is of formula Si(OR)4 where R is alkyl, such as a tetraethyl orthosilicate. Fluoroalkoxysilane is of formula Si(OR1)nF4-n where R1 is alkyl, preferably, is fluorotriethoxysilane. The decomposition of the gaseous mixture is performed at approximately 200 °C in the presence of ozone gas, under UV radiation or gas plasma.

EP-A-0 654 545 discloses a semiconductor device thin film formation method in which multiple ac power sources of differing frequencies or a power source of a single frequency is used to generate a plasma in a reactor vessel; by activating a reaction gas introduced to this reaction vessel using plasma discharge energy, a deposit is formed by chemical growth of the reaction gas and deposited on a sample surface; a mixed gas of TEOS gas with a SiXnR4-n (where 1 </= n </= 3, Si is silicon, X is a halogen substituent, and R is an alkoxy group) silicon halide hydrocarbon gas is used as the reaction gas.

US-A-5 429 995 teaches the use of organic silane gases such as HSi(OC2 H5)3 and H2 Si(C4 H9)2 in place of TEOS. Further, it is possible to use gaseous F-containing compounds such as CF4, CIF3 and SiF4 in place of NF3.

As one approach for reducing the parasitic capacitance, it may be considered to reduce the relative dielectric constant ($\varepsilon$) of the interlayer insulating film. Currently, the followings are taken as countermeasures.

(1) Using an organic resin film. It has been reported that the interlayer insulating film of the relative dielectric constant of less than $\varepsilon=3.0$ is used.
(2) Using a Teflon-based insulating film. The interlayer insulating film of the relative dielectric constant of less than $\varepsilon=3.0$ has been reported.
(3) Using an SiBN film or SiOBN film. An example has been reported in which the interlayer insulating film is formed by sputtering.
(4) Using either an $SiO_2$ film with Si-F bond or $SiO_2$ film including F.

However, in the cases of (1) and (2), since the interlayer insulating film is formed of the substance which is totally different from $SiO_2$, sufficient reliability

and stability of the film cannot be achieved. In addition, evaluation for its application to the devices has not progressed, and therefore applicability of such insulating film is not certain or confirmed in practical use.

In turn, in the cases of (3), since such insulating film has high hygroscopicity, it is not suitable for application to the semiconductor device. Moreover, this is a method for forming a BSG film by causing SiOB source (organic compound having SiOB bond, for instance, tristrimethylsilylborate) to react with ozone to form the BSG film, which is in the middle of research and development.

Besides, in the cases of (4), the fluorine (F) - containing silicon oxide film may be formed by various ways, and technique for providing about 3.4 to 3.6 as the value of relative dielectric constant ($\varepsilon$) is being investigated and developed. At all events, it is important to form the fluorine - containing silicon oxide film which is stable in quality.

In the prior art, the followings may be exemplified as the method for forming the fluorine - containing silicon oxide film.

(1) Hydrolysis of fluorotriethoxysilane (SiF$(OC_2H_5)_3$),
(2) Plasma CVD method using triethoxysilane (TEOS), $C_2F_6$, and oxygen ($O_2$),
(3) Plasma CVD method or ECR plasma CVD method using $SiF_4$ and oxygen ($O_2$), and
(4) Plasma CVD method using SiF$(OC_2H_5)_3$ and oxygen ($O_2$).

In the above methods, the plasma CVD method is employed as the film forming method except for the method (1). The values $\varepsilon$ =3.4 to 3.6 of relative dielectric constant have already been achieved by these methods.

However, these fluorine containing silicon oxide films are prone to absorb moisture, as a result of which a relative dielectric constant of the silicon oxide films is increased. In other words, the silicon oxide films are inferior in water resistance.

In particular, if being formed by the plasma CVD method, the silicon oxide films exhibit poor step coverage, so that they are not suitable to be filled into minute spaces. Although ECR plasma CVD method is the most stable one of various plasma CVD methods, it is not fitted for mass production because of its large scaled equipment. In addition, SiF$(OC_2H_5)_3$ has Si-F bond originally as source material, but it is difficult to keep the bond in the plasma as it is and therefore it is hard to accomplish the silicon oxide film in which fluorine is contained properly by controlling fluorine density.

## SUMMARY OF THE INVENTION

It is an object of the present invention to provide a film forming method capable of forming a fluorine - containing silicon oxide film which is superior in step coverage, of a small relative dielectric constant, and stable in film quality.

In the present invention, organic silane having Si-F bond is used as a source gas by the inventors. This source gas is extremely easy to be decomposed, and thus hydrolysis and oxidation reaction of the source gas are caused at the normal temperature. In order to suppress such decomposition, organic silane having no Si-F bond has to be added to the source gas in proper quantity. The fluorine - containing silicon oxide film is formed by virtue of reaction of the source gas with ozone in the situation where a substrate is being heated. At this time, it is preferable that the substrate temperature is held in the range of 300 to 400 °C to accomplish proper deposition rate and good quality of the silicon oxide film.

In the fluorine - containing silicon oxide film formed as mentioned above, relative dielectric constant can be controlled according to an amount of contained fluorine. As a rule, the more an amount of contained fluorine, the lower the relative dielectric constant. Since the fluorine - containing silicon oxide film is formed by thermal CVD method, it is superior in step coverage.

Furthermore, with the use of reforming process for exposing the fluorine - containing silicon oxide film to oxygen or nitrogen plasma, moisture contained in the film can be removed to thus lower the relative dielectric constant much more. In addition, denseness of the silicon oxide film can be increased by plasma irradiation process to thus result in increased water resistance of the silicon oxide film. Consequently, variation in the relative dielectric constant with elapsed time can be suppressed and therefore low relative dielectric constant can be maintained.

## BRIEF DESCRIPTION OF THE DRAWINGS

FIG.1 is a schematic view showing a film forming apparatus for use in formation of a fluorine - containing silicon oxide film according to an embodiment of the present invention;
FIG.2 is a schematic view showing a plasma processing apparatus for use in plasma processing of the fluorine - containing silicon oxide film according to the embodiment of the present invention;
FIG.3 is a characteristic view illustrative of a relationship between deposition rate and deposition temperature of the fluorine - containing silicon oxide film formed by a film forming method according to the embodiment of the present invention;
FIG.4 is a characteristic view illustrative of a relationship between deposition rate and flow rate of F-TES of the fluorine - containing silicon oxide film formed by the film forming method according to the embodiment of the present invention;

FIG.5 is a characteristic view illustrative of a relationship between refractive index and deposition temperature of the fluorine - containing silicon oxide film formed by the film forming method according to the embodiment of the present invention;

FIG.6 is a characteristic view illustrative of a relationship between refractive index and flow rate of F-TES of the fluorine - containing silicon oxide film formed by the film forming method according to the embodiment of the present invention;

FIG.7 is a characteristic view illustrating the results of infrared absorption in the fluorine - containing silicon oxide film formed by the film forming method according to the embodiment of the present invention after it being subjected to plasma irradiation process; and

FIG.8 is a characteristic view illustrating a quality improving effect due to the plasma irradiation process on the fluorine - containing silicon oxide film formed by the film forming method according to the embodiment of the present invention.

DESCRIPTION OF THE PREFERRED EMBODIMENT

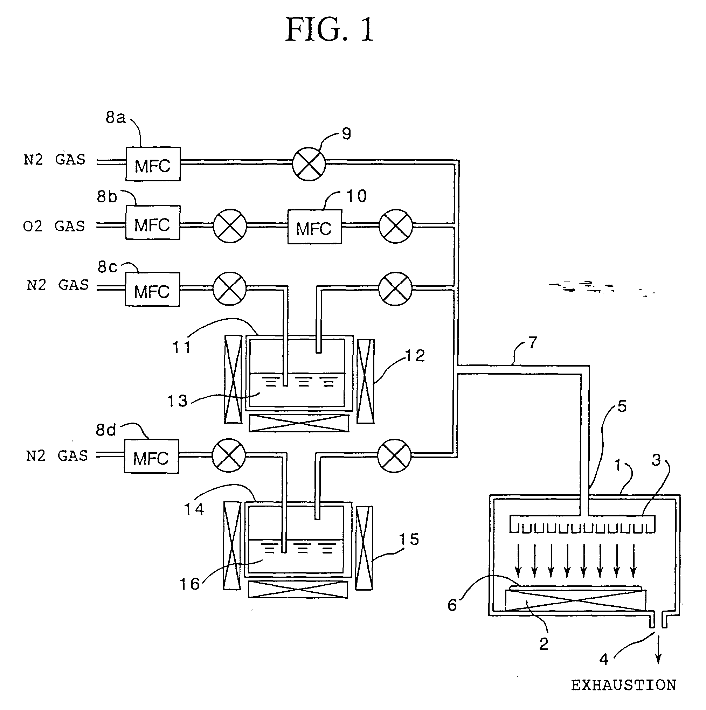

A film forming system which is used to form a fluorine - containing silicon oxide film according to an embodiment of the present invention will be explained at first hereinafter with reference to FIG.1.

FIG.1 is a schematic view showing a configuration of a thermal CVD apparatus comprising a reaction gas supplying section and a film forming section.

As shown in FIG.1, a wafer loading table 2 having a built-in heater therein and a gas discharging portion 3 are furnished with a film forming chamber 1. An exhaust port 4 and a gas introducing port 5 are provided in the film forming chamber 1. Reaction gas is introduced from the gas introducing port 5 into the film forming chamber 1 via a pipe 7 while unnecessary reaction gas is exhausted from the exhaust port 4 to the outside of the film forming chamber 1. Mixed reaction gas is supplied to the pipe 7 from the reaction gas supplying portion. The reaction gas supplying portion is equipped with a plurality of branch pipes which are connected to respective gas sources corresponding to gas to be used. In the embodiment of the present invention, the branch pipes comprise a first branch pipe for supplying nitrogen gas, a second branch pipe for supplying ozone ($O_3$) containing oxygen gas, a third branch pipe for supplying organic silane with Si-F bond, e.g., fluorotriethoxysilane (F-TES), and a fourth branch pipe for supplying organic silane without Si-F bond, e.g., tetraethoxysilane (TEOS).

To the first branch pipe are provided a port for introducing nitrogen gas, a mass flow controller (MFC) 8a, and a switching valve 9 which may cut off/introduce gas flow. In the course of the second branch pipe between a port for introducing oxygen gas and the pipe 7 are interposed a mass flow controller (MFC) 8b, an ozone generating unit 10, and switching valves 9 which may cut off/introduce gas flow. The ozone generating unit 10 may convert oxygen gas into ozone in proper quantity so as to adjust the ozone density in oxygen gas.

To the third branch pipe are provided an introducing port for carrier gas (nitrogen gas), a mass flow controller (MFC) 8c, a container 11 containing F-TES solution 13 therein, a heater 12 for heating the F-TES solution 13, and switching valves 9 which may cut off/introduce gas flow. Nitrogen gas including F-TES in virtue of bubbling of the carrier gas (nitrogen gas) can be supplied to the pipe 7.

In the middle of the fourth branch pipe between a port for introducing carrier gas (nitrogen gas) and the pipe 7 are interposed a mass flow controller (MFC) 8d, a container 14 containing TEOS solution 16 therein, a heater 15 for heating the TEOS solution 16, and switching valves 9 which may cut off/introduce gas flow. Nitrogen gas including TEOS in virtue of bubbling of the carrier gas (nitrogen gas) can be supplied to the pipe 7.

Subsequently, referring to FIG.1, there will be explained a method for forming the fluorine - containing silicon oxide film according to the embodiment of the present invention based on an atmospheric pressure CVD method.

First a wafer 6 is placed on the wafer loading table 2 positioned at the bottom of the film forming chamber 1 and then heated. For purposes of experiment, the temperature of the wafer 6 is varied film by film within the range of 100 to 350 °C.

In turn, the F-TES solution 13 is heated and then held at the temperature of 40 °C. At the same time, the TEOS solution 16 is heated and then held at the temperature of 65 °C.

Next, all switching valves 9 provided on respective branch pipes are opened. More particularly, nitrogen gas is supplied at flow rate of 18 SLM to the pipe 7 via the first branch pipe, oxygen gas including ozone by 2.4 % is supplied at flow rate of 7.5 SLM to the pipe 7 via the second branch pipe, nitrogen gas including F-TES is supplied to the pipe 7 via the third branch pipe, and nitrogen gas including TEOS is supplied at flow rate of 2.0 SLM to the pipe 7 via the fourth branch pipe. These gases are then mixed and supplied to the film forming chamber 1. For purposes of experiment, flow rate of nitrogen gas including F-TES is varied within the range of 0.5 to 3.0 SLM.

Mixed gas is discharged toward the wafer 6 from the gas discharging portion 3 in the film forming chamber 1 to start film forming processes. With holding such condition for a predetermined time, the fluorine - containing silicon oxide film is formed on the wafer 6 to have a predetermined thickness.

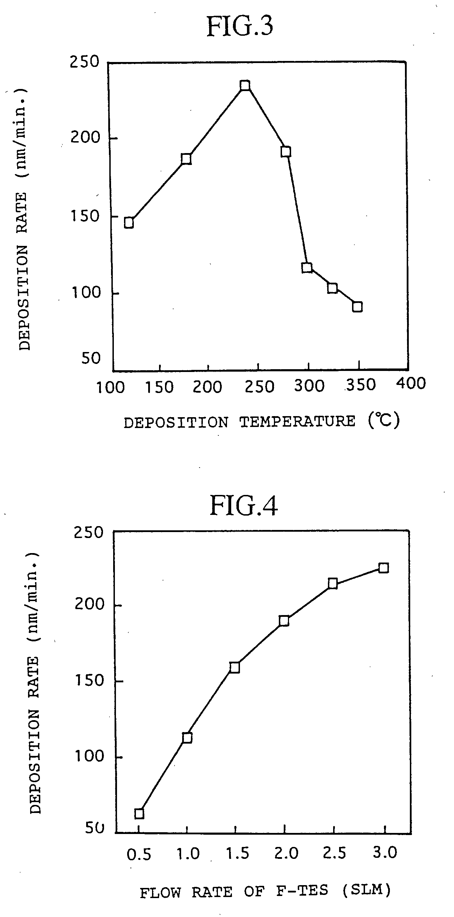

FIG.3 shows a correlation of the deposition rate with the deposition temperature. An ordinate represents the deposition rate (nm/min) in linear scale while an abscissa represents the deposition temperature (°C) in linear scale. The flow rate of F-TES is kept constant at 2.0 SLM. As shown in FIG.3, the deposition rate assumes its maximum value of about 250 nm/min at almost 250 °C.

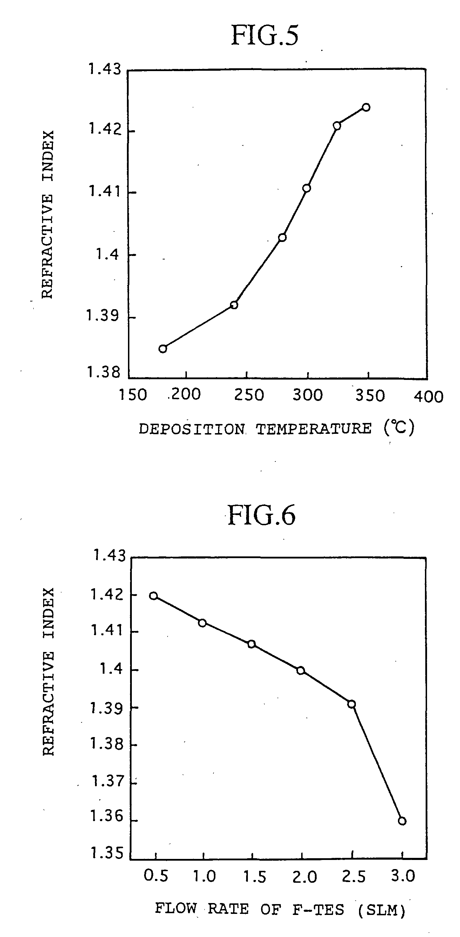

FIG.5 shows a relationship between the refractive index of the fluorine - containing silicon oxide film obtained and the deposition temperature. An ordinate represents the refractive index in linear scale while an abscissa represents the deposition temperature (°C) in linear scale. The flow rate of F-TES is maintained constant at 2.0 SLM.

As shown in FIG.5, the refractive index is about 1.385 at the deposition temperature of 180 °C. The refractive index is then increased linearly with the increase in the deposition temperature. Finally the refractive index becomes about 1.425 at the substrate temperature of 350 °C.

With this change of the refractive index, it can be understood that fluorine is hard to be introduced in the film as the deposition temperature is increased. In other words, the lower the deposition temperature, the smaller the refractive index.

A relationship between the flow rate of F-TES and the deposition rate is shown in FIG.4. An ordinate represents the deposition rate (nm/min) in linear scale while an abscissa represents the flow rate of F-TES (SLM) in linear scale. The substrate temperature is held constant at 280 °C.

As shown in FIG.4, the deposition rate is increased linearly with the increase in flow rate of F-TES, and the deposition rate reaches about 230 nm/min at the flow rate of F-TES of 3.0 SLM.

FIG.6 shows a relationship between the refractive index of the fluorine - containing silicon oxide film formed and the flow rate of F-TES. An ordinate represents the refractive index in linear scale while an abscissa represents the flow rate of F-TES (SLM) in linear scale. The substrate temperature is kept constant at 280 °C.

As shown in FIG.6, the refractive index is about 1.42 at the flow rate of F-TES of 0.5 SLM. The refractive index is then decreased gradually with the increase in the flow rate of F-TES. Finally the refractive index becomes about 1.36 at the flow rate of F-TES of 3.0 SLM. It would be appreciated from the above that fluorine is easy to be introduced in the film as the flow rate of F-TES is increased. In other words, the more the flow rate of F-TES, the smaller the refractive index.

In the fluorine - containing silicon oxide film formed as mentioned above, relative dielectric constant can be controlled according to an amount of contained fluorine. In general, the more an amount of contained fluorine, the lower the relative dielectric constant. Since the fluorine - containing silicon oxide film is formed by thermal CVD method, it is superior in step coverage.

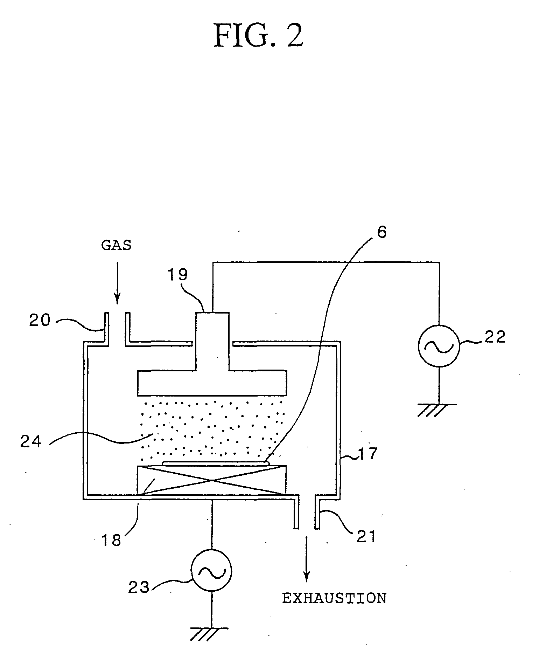

Then, after the film being formed, plasma process is carried out by the plasma processing apparatus shown in FIG.2.

In FIG.2, the wafer 6 on which the fluorine - containing silicon oxide film is formed is placed on the wafer loading table 18 of the plasma processing apparatus. The wafer 6 is then heated and thereafter maintained at 370 °C.

Succeedingly, an inside of a chamber 17 is exhausted to lower the pressure. After the pressure in the chamber 17 reaches predetermined reduced pressure, the gas is introduced from the gas introducing port 20 into the chamber 17. With the use of oxygen ($O_2$) and nitrogen ($N_2$) as the introduced gas respectively, for the sake of experiment, advantages obtained are compared with each other.

Next, an electric power of 400 W having a frequency of 13.56 MHz is applied from a power source 22 to an upper electrode 19, and at the same time an electric power of 400 W having a frequency of 100 kHz is applied from a power source 23 to a lower electrode 18. Consequently, the gas is plasmanized and the wafer 6 is biased negatively, so that the fluorine - containing silicon oxide film formed on the wafer 6 is subjected to irradiation of plasma 24. After about 300 sec is elapsed, plasma irradiation is ceased and then the wafer 6 is taken out of the chamber 17.

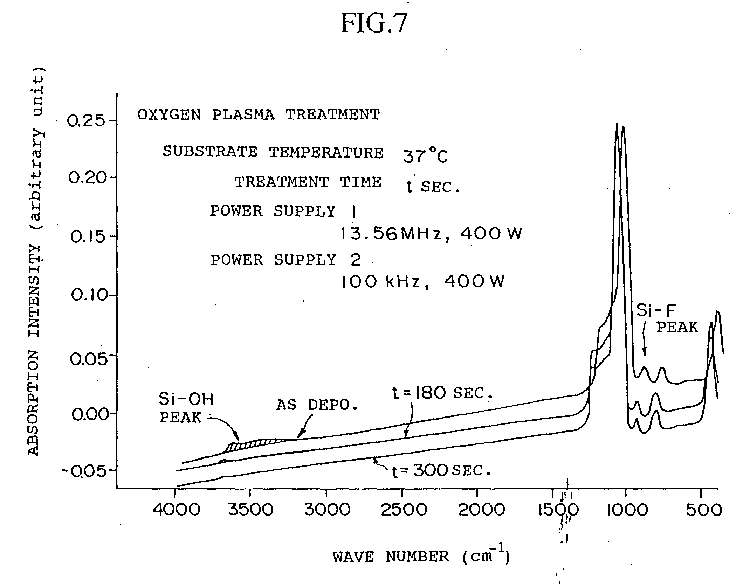

Then, the measured results of the infrared absorption characteristics after plasma irradiation are shown in FIG.7. An ordinate represents the absorption intensity in arbitrary unit while an abscissa represents the number of wave ($cm^{-1}$) in linear scale. Three kinds of measured results, i.e., results obtained immediately after film formation, after plasma irradiation for 180 sec, and 300 sec, are compared with each other in FIG.7.

In FIG.7, although a Si-OH peak remains immediately after film formation, it can be reduced after plasma irradiation for 180 sec and then it can disappear completely after plasma irradiation for 300 sec. This means that moisture which is included in the fluorine - containing silicon oxide film immediately after film formation can be removed by plasma irradiation process. In addition, since denseness of the silicon oxide film can be increased by plasma irradiation process, water resistance of the silicon oxide film can be improved. As a result, variation in the relative dielectric constant with elapsed time can be suppressed and therefore low relative dielectric constant can be maintained.

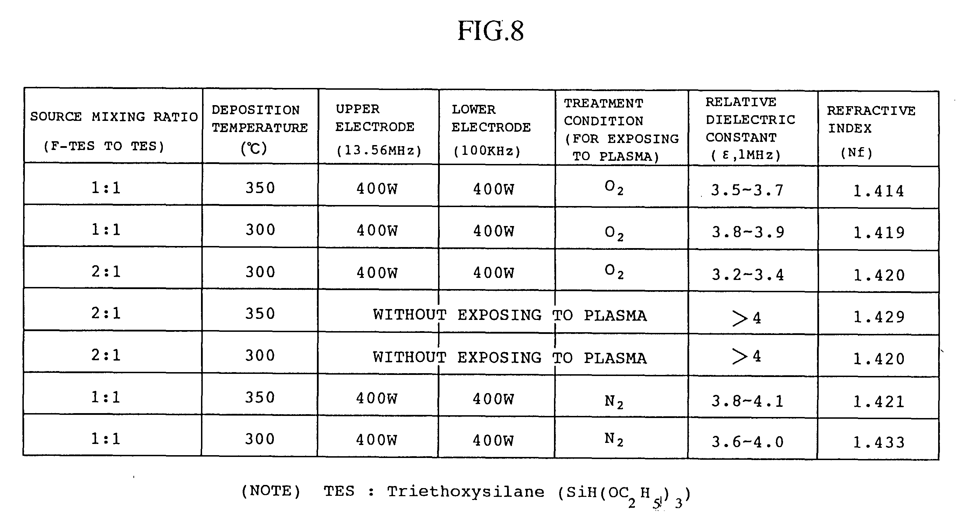

Next, a reforming effect due to the plasma irradiation process on the fluorine - containing silicon oxide film formed will be illustrated in a Table of FIG.8. Where triethoxysilane (TES) is used as organic silane including no fluorine.

As shown in FIG.8, the relative dielectric constant ε can be lowered by enhancing a mixing ratio of the organic silane including fluorine to the organic silane including no fluorine to show the value of 3.2 to 3.4 after the plasma irradiation is carried out. Even in the event that the mixing ratio is enhanced, the silicon oxide film still has the large relative dielectric constant ε unless the plasma irradiation is carried out. In the above plasma process, the process gas using oxygen gas is of advantage to the small relative dielectric constant rather than that using nitrogen gas.

With the above, it can be appreciated that the relative dielectric constant may be lowered much more and advantage derived from included fluorine may be enhanced much more if the plasma process is carried out after film formation.

In the above embodiment, fluorotriethoxysilane (F-TES) which is fluoroalkoxysilane has been used as organic silane having Si-F bond. However, other fluoroalkoxysilane ($SiF_n(OR)_{4-n}$, n=1 to 3, R is alkyl group, aryl group, or their derivative), fluoroalkylsilane ($SiF_nR_{4-n}$, n=1 to 3, R is alkyl group, aryl group, or their derivative), chain fluorosiloxane ($R_nF_{3-n}SiO(R_kF_{2-k}SiO)_mSiF_{3-n}R_n$, n=1, 2, k= 0 to 2, m$\geqq$0, R is alkyl group, aryl group, or their derivative), or ring fluorosiloxane (($R_kF_{2-k}SiO)_m$, k=1, m$\geqq$2, R is alkyl group, aryl group, or their derivative) may be used as organic silane having Si-F bond.

In addition, TEOS or TES which is alkoxysilane has been used in the above embodiment as organic silane having no Si-F bond. However, other alkoxysilane ($SiH_n(OR)_{4-n}$, n=1 to 3, R is alkyl group, aryl group, or their derivative), alkylsilane ($SiH_nR_{4-n}$, n=1 to 3, R is alkyl group, aryl group, or their derivative), chain siloxane ($R_nH_{3-n}SiO(R_kH_{2-k}SiO)_mSiH_{3-n}R_n$, n=1, 2, k= 0 to 2, m$\geqq$0, R is alkyl group, aryl group, or their derivative), or ring siloxane (($R_kH_{2-k}SiO)_m$, k=1, m$\geqq$2, R is alkyl group, aryl group, or their derivative) may be used as organic silane having no Si-F bond.

As has been explained, according to the film forming method of the present invention, the fluorine - containing silicon oxide film is formed by thermal CVD method using organic silane having Si-F bond as a source gas.

The relative dielectric constant of the fluorine - containing silicon oxide film formed as mentioned above can be controlled by adjusting an amount of contained fluorine. In general, the more an amount of contained fluorine, the lower the-relative dielectric constant. Since the fluorine - containing silicon oxide film is formed by thermal CVD method, it is superior in step coverage.

Furthermore, with the use of reforming process for exposing the fluorine - containing silicon oxide film to oxygen or nitrogen plasma, moisture contained in the film can be removed. In addition, denseness of the silicon oxide film can be increased by plasma irradiation process to thus increase water resistance of the silicon oxide film. Thereby, variation in the relative dielectric constant with elapsed time can be suppressed and therefore low relative dielectric constant can be maintained.

## Claims

1. A method for forming a film comprising the steps of forming a fluorine-containing silicon oxide film on a substrate (6) by means of thermal reaction of mixed gas while said substrate (6) is being heated, said mixed gas including organic silane having Si-F bond, organic silane having no Si-F bond, and ozone-containing gas; and exposing said fluorine-containing silicon oxide film to plasma including at least one of oxygen and nitrogen under the condition where said substrate is being heated after said fluorine-containing silicon oxide film is formed on said substrate.

2. A method for forming a film according to claim 1, wherein said fluorine-containing silicon oxide film is formed at atmospheric pressure.

3. A method for forming a film according to claim 1 or 2, wherein said organic silane having Si-F bond is composed of fluoroalkoxysilane ($SiF_n(OR)_{4-n}$, n=1 to 3, R is alkyl group, aryl group, or their derivative), fluoroalkylsilane ($SiF_nR_{4-n}$, n=1 to 3, R is alkyl group, aryl group, or their derivative), chain fluorosiloxane ($R_nF_{3-n}SiO(R_kF_{2-k}SiO)_mSiF_{3-n}R_n$, n=1, 2, k= 0 to 2, m$\geqq$0, R is alkyl group, aryl group, or their derivative), or ring fluorosiloxane (($R_kF_{2-k}SiO)_m$, k=1, m$\geqq$2, R is alkyl group, aryl group, or their derivative).

4. A method for forming a film according to claim 1 or 2, wherein said organic silane having no Si-F bond is composed of alkoxysilane ($SiH_n(OR)_{4-n}$, n=1 to 3, R is alkyl group, aryl group, or their derivative), alkylsilane ($SiH_nR_{4-n}$, n=1 to 3, R is alkyl group, aryl group, or their derivative), chain siloxane ($R_nH_{3-n}SiO(R_kH_{2-k}SiO)_mSiH_{3-n}R_n$, n=1, 2, k= 0 to 2, m$\geqq$0, R is alkyl group, aryl group, or their derivative), or ring siloxane (($R_kH_{2-k}SiO)_m$, k=1, m$\geqq$2, R is alkyl group, aryl group, or their derivative).

5. A method for forming a film according to claim 1, 2, 3 or 4, wherein said ozone-containing gas is composed of ozone ($O_3$) and oxygen ($O_2$).

6. A method for forming a film according to claim 1, wherein said plasma including at least one of oxygen and nitrogen is plasma of $O_2$, NO, $NO_2$, or $N_2O$.

## Patentansprüche

1. Verfahren zur Bildung eines Films, umfassend die Schritte des Bildens eines Fluor-enthaltenden Siliziumoxidfilms auf einem Substrat (6) mittels thermischer Reaktion eines gemischten Gases, während das Substrat (6) erwärmt wird, wobei das gemischte Gas ein organisches Silan mit einer Si-F-Bindung, organisches Silan ohne Si-F-Bindung und ein Ozon-enthaltendes Gas umfasst; und Exponieren des Fluor-enthaltenen Siliziumoxidfilms an ein Plasma, enthaltend mindestens eines von Sauerstoff und Stickstoff, unter der Bedingung, bei der das Substrat erwärmt wird, nachdem der Fluor-enthaltende Siliziumoxidfilm auf dem Substrat gebildet worden ist.

2. Verfahren zur Bildung eines Films gemäß Anspruch 1, worin der Fluor-enthaltende Siliziumoxidfilm bei atmosphärischem Druck gebildet wird.

3. Verfahren zur Bildung eines Films gemäß Anspruch 1 oder 2, worin das organische Silan mit Si-F-Bindung zusammengesetzt ist aus Fluoralkoxysilan ($SiF_n(OR)_{4-n}$, n=1 bis 3, R ist eine Alkylgruppe, Arylgruppe oder deren Derivat), Fluoralkylsilan ($SiF_nR_{4-n}$, n=1 bis 3, R ist eine Alkylgruppe, Arylgruppe oder deren Derivat), einem Kettenfluorsiloxan ($R_nF_{3-n}SiO(R_kF_{2-k}SiO)_mSiF_{3-n}R_n$, n=1, 2, k=0 bis 2, m$\geq$0, R ist eine Alkylgruppe, Arylgruppe oder deren Derivat) oder einem ringförmigen Fluorsiloxan (($R_kF_{2-k}SiO)_m$, k=1, m$\geq$2, R ist eine Alkylgruppe, Arylgruppe oder deren Derivat).

4. Verfahren zur Bildung eines Films gemäß Anspruch 1 oder 2, worin das organische Silan ohne Si-F-Bindung zusammengesetzt ist aus Alkoxysilan ($SiH_n(OR)_{4-n}$, n=1 to 3, R ist eine Alkylgruppe, Arylgruppe oder deren Derivat), Alkylsilan ($SiH_nR_{4-n}$, n=1 bis 3, R ist eine Alkylgruppe, Arylgruppe oder deren Derivat), einem Kettensiloxan ($R_nH_{3-n}SiO(R_kH_{2-k}SiO)_mSiH_{3-n}R_n$, n=1, 2, k=0 bis 2, m$\geq$0, R ist eine Alkylgruppe, Arylgruppe oder deren Derivat), oder einem ringförmigen Siloxan (($R_kH_{2-k}SiO)_m$, k=1, m$\geq$2, R ist eine Alkylgruppe, Arylgruppe oder deren Derivat).

5. Verfahren zur Bildung eines Films gemäß Anspruch 1, 2, 3 oder 4, worin das Ozon-enthaltende Gas zusammengesetzt ist aus Ozon (03) und Sauerstoff ($O_2$).

6. Verfahren zur Bildung eines Films gemäß Anspruch 1, worin das Plasma, enthaltend mindestens eines von Sauerstoff und Stickstoff, ein Plasma von $O_2$, NO, $NO_2$ oder $N_2O$ ist.

**Revendications**

1. Procédé de formation d'une couche comprenant les étapes consistant à former une couche d'oxyde de silicium contenant du fluor sur un substrat (6) au moyen d'une réaction thermique d'un mélange de gaz tout en chauffant ledit substrat (6), ledit mélange de gaz comprenant un silane organique avec liaison Si-F, un silane organique sans liaison Si-F, et un gaz contenant de l'ozone ;
et à exposer ladite couche d'oxyde de silicium contenant du fluor à un plasma contenant de l'oxygène et/ou de l'azote, à la condition que ledit substrat soit chauffé après que ladite couche d'oxyde de silicium contenant du fluor a été formée sur ledit substrat.

2. Procédé de formation d'une couche selon la revendication 1, dans lequel ladite couche d'oxyde de silicium contenant du fluor est formée à pression atmosphérique.

3. Procédé de formation d'une couche selon la revendication 1 ou 2, dans lequel ledit silane organique avec liaison Si-F est composé de fluoroalcoxysilane ($SiF_n(OR)_{4-n}$, n = 1 à 3, R est un groupe alkyle, un groupe aryle, ou leur dérivé), fluoroalkylsilane ($SiF_nR_{4-n}$, n = 1 à 3, R est un groupe alkyle, un groupe aryle, ou leur dérivé), une chaîne fluorosiloxane ($R_nF_{3-n}SiO(R_kF_{2-k}SiO)_mSiF_{3-n}R_n$, n = 1, 2, k = 0 à 2, m $\geq$ 0, R est un groupe alkyle, un groupe aryle, ou leur dérivé), ou un cycle fluorosiloxane (($R_kF_{2-k}SiO)_m$, k = 1, m $\geq$ 2, R est un groupe alkyle, un groupe aryle, ou leur dérivé).

4. Procédé de formation d'une couche selon la revendication 1 ou 2, dans lequel ledit silane organique sans liaison Si-F est composé d'alcoxysilane ($SiH_n(OR)_{4-n}$, n = 1 à 3, R est un groupe alkyle, un groupe aryle, ou leur dérivé), alkylsilane ($SiH_nR_{4-n}$, n = 1 à 3, R est un groupe alkyle, un groupe aryle, ou leur dérivé), une chaîne siloxane ($R_nH_{3-n}SiO(R_kH_{2-k}SiO)_mSiH_{3-n}R_n$, n = 1, 2, k = 0 à 2, m $\geq$ 0, R est un groupe alkyle, un groupe aryle, ou leur dérivé), ou un cycle siloxane (($R_kH_{2-k}SiO)_m$, k = 1, m $\geq$ 2, R est un groupe alkyle, un groupe aryle, ou leur dérivé).

5. Procédé de formation d'une couche selon la revendication 1, 2, 3 ou 4, dans lequel ledit gaz contenant de l'ozone est composé d'ozone ($O_3$) et d'oxygène ($O_2$).

6. Procédé de formation d'une couche selon la revendication 1, dans lequel ledit plasma contenant de l'oxygène et/ou de l'azote est un plasma de $O_2$, NO, $NO_2$ ou $N_2O$.

# FIG. 1

N2 GAS — MFC 8a — 9

O2 GAS — MFC 8b — 10 MFC

N2 GAS — MFC 8c

11 — 12
13

N2 GAS — MFC 8d

14
16 — 15

7

5
1 3
6
2
4

EXHAUSTION

# FIG. 2

GAS

20

19

6

22

24

17

18

23

21

EXHAUSTION

## FIG.3

## FIG.4

## FIG.5

## FIG.6

# FIG.7

**ABSORPTION INTENSITY (arbitrary unit)** vs **WAVE NUMBER (cm⁻¹)**

OXYGEN PLASMA TREATMENT

SUBSTRATE TEMPERATURE  37°C

TREATMENT TIME  $t$ SEC.

POWER SUPPLY 1
   13.56MHz, 400 W

POWER SUPPLY 2
   100 kHz, 400 W

Si-OH PEAK

AS DEPO.

$t$ = 180 SEC.

$t$ = 300 SEC.

Si-F PEAK

## FIG.8

| SOURCE MIXING RATIO (F-TES TO TES) | DEPOSITION TEMPERATURE (°C) | UPPER ELECTRODE (13.56MHz) | LOWER ELECTRODE (100KHz) | TREATMENT CONDITION (FOR EXPOSING TO PLASMA) | RELATIVE DIELECTRIC CONSTANT ($\varepsilon$, 1MHz) | REFRACTIVE INDEX (Nf) |
|---|---|---|---|---|---|---|
| 1:1 | 350 | 400W | 400W | $O_2$ | 3.5~3.7 | 1.414 |
| 1:1 | 300 | 400W | 400W | $O_2$ | 3.8~3.9 | 1.419 |
| 2:1 | 300 | 400W | 400W | $O_2$ | 3.2~3.4 | 1.420 |
| 2:1 | 350 | WITHOUT EXPOSING TO PLASMA | | | $>4$ | 1.429 |
| 2:1 | 300 | WITHOUT EXPOSING TO PLASMA | | | $>4$ | 1.420 |
| 1:1 | 350 | 400W | 400W | $N_2$ | 3.8~4.1 | 1.421 |
| 1:1 | 300 | 400W | 400W | $N_2$ | 3.6~4.0 | 1.433 |

(NOTE)  TES : Triethoxysilane ($SiH(OC_2H_5)_3$)